# EUROPÄISCHE PATENTSCHRIFT

(11) **EP 2 057 697 B1**
(45) Veröffentlichungstag und Bekanntmachung des Hinweises auf die Patenterteilung: **04.07.2012**
(21) Anmeldenummer: 07801142.6
(22) Anmeldetag: 11.07.2007
(51) Int. Cl.: H01L 41/053, H01L 41/083, H01L 41/24

(54) **PIEZOKERAMISCHER FLÄCHENAKTOR UND VERFAHREN ZUR HERSTELLUNG EINES SOLCHEN**
PIEZOCERAMIC SURFACE ACTUATOR AND METHOD FOR THE PRODUCTION THEREOF
ACTIONNEUR PIÉZOCÉRAMIQUE PLAN ET PROCÉDÉ POUR LA FABRICATION DE CE DERNIER

(30) Priorität: 29.08.2006 DE 102006040316
(43) Veröffentlichungstag der Anmeldung: 13.05.2009
(73) Patentinhaber: Deutsches Zentrum für Luft- und Raumfahrt e.V., 51147 Köln (DE)
(72) Erfinder: WIERACH, Peter, 38106 Braunschweig (DE)
(74) Vertreter: Gerstein, Hans Joachim
(86) Internationale Anmeldenummer: PCT/DE2007/001235
(87) Internationale Veröffentlichungsnummer: WO 2008/025315

(56) Entgegenhaltungen:
- EP-A- 0 509 488
- EP-A- 1 090 835
- WO-A-2005/067071
- DE-A1- 19 928 189

## Beschreibung

Die Erfindung betrifft einen piezokeramischen Flächenaktuator mit Multilayerplatten, die eine Vielzahl von durch jeweils eine positive oder negative Elektrode voneinander getrennte Piezokeramikplatten haben, wobei sich die positiven und negativen Elektroden alternierend abwechseln und integral mit den Piezokeramikplatten aufgebaut sind und mit Sammelelektrodenflächen für die positiven und negativen Elektroden, die mit den zugeordneten positiven oder negativen Elektroden leitend verbunden und auf sich zwei gegenüberliegenden Außenflächen der Multilayerplatten angeordnet sind, wobei die Multilayerplatten plattenförmig mit einer wesentlich größeren durch den Abstand der gegenüberliegenden Sammelelektrodenflächen definierten Breite der Multilayerplatten als der Dicke der Multilayerplatten sind.

Die Erfindung betrifft weiterhin ein Verfahren zur Herstellung eines piezokeramischen Flächenaktuators mit den Schritten:
a) Herstellen eines monolithischen quaderförmigen Keramikblocks bestehend aus einer Vielzahl von durch jeweils eine positive oder negative Elektrode voneinander getrennten Piezokeramikplatten, wobei sich die positiven und negativen Elektroden alternierend abwechseln und integral mit den Piezokeramikplatten aufgebaut sind,
b) Aufbringen von elektrisch leitenden Sammelelektrodenflächen auf zwei sich gegenüberliegenden Außenseiten des Flächenaktuators derart, dass die Sammelelektrodenflächen mit den zugeordneten positiven oder negativen Elektroden leitend verbunden werden.

Aktuatoren und Sensoren auf Basis multifunktionaler Werkstoffe sind ein wesentlicher Bestandteil adaptiver Strukturen. Als integrale Komponenten der Struktur übernehmen sie im günstigsten Fall auch lasttragende Funktion. Multifunktionale Werkstoffe, häufig auch als "Smart Materials" oder intelligente Werkstoffe bezeichnet, sind Energiewandler, die in einer technisch nutzbaren Weise auf einen äußeren Stimulus reagieren. Am häufigsten eingesetzt werden Werkstoffe, die auf ein elektrisches, thermisches oder magnetisches Feld mit einer Änderung ihrer mechanischen Eigenschaften reagieren. Die bekanntesten Vertreter sind Piezokeramiken (Kraftwirkung/Deformation im elektrischen Feld), Formgedächtnislegierung (temperaturabhängige Kraftwirkung/Deformation) oder elektrorheologische und magnetorheologische Flüssigkeiten (Beeinflussung der Schubübertragung im elektrischen bzw. magnetischen Feld). Häufig funktioniert der Effekt in beide Richtungen, so dass die entsprechenden Werkstoffe nicht nur aktuatorisch, sondern auch sensorisch genutzt werden können.

Aufgrund einer Reihe von Vorteilen sind hierzu Piezokeramiken die gegenwärtig am häufigsten verwendeten multifunktionalen Werkstoffe. Die Funktion von Piezokeramiken basiert auf dem piezoelektrischen Effekt, der die Wechselwirkung zwischen dem mechanischen und elektrischen Zustand einer speziellen Klasse von Kristallen beschreibt. Entstehen proportional zur Deformation des Kristalls elektrische Ladungen, so wird dies als direkter piezoelektrischer Effekt bezeichnet. Dieser Effekt kann sensorisch genutzt werden, indem die elektrischen Ladungen über ein geeignetes Messinstrument detektiert werden. Die Umkehrung dieses Effektes wird inverser piezoelektrischer Effekt genannt, bei dem das Kristall seine Form unter dem Einfluss eines elektrischen Feldes ändert. Über diesen Effekt erfolgt die aktuatorische Nutzung der Piezokeramik.

Piezokeramische Werkstoffe haben den Vorteil, dass sie in einem großen Frequenzbereich bis weit in den KHz-Bereich hinein eingesetzt werden können, eine hohe Steifigkeit von typischerweise 60 GPa aufweisen und über ein elektrisches Feld einfach angesteuert werden können.

Die Piezokeramiken werden großindustriell hergestellt und sind von verschiedenen Anbietern in unterschiedlichen Bauformen zu einem günstigen Preis erhältlich. Ein Nachteil von Piezokeramiken liegt jedoch in der Natur keramischer Werkstoffe begründet. Piezokeramiken sind spröde und damit bruchempfindlich. Während sie Druckbelastungen sehr gut standhalten können, sind Zugbelastungen auf jeden Fall zu vermeiden. Die zuverlässige Weiterverarbeitung und strukturelle Integration der in der Regel höchstempfindlichen Werkstoffe ist daher mit einigem Aufwand und Risiko verbunden.

Ein vorteilhaftes und industriegerechtes Konzept ist es daher, die jeweiligen Werkstoffe zunächst zu kompakten und handhabbaren Bauelementen in Form von Piezokompositen weiter zu verarbeiten. Piezokomposite sind Verbundwerkstoffe bestehend aus piezokeramischen Materialien und Polymerwerkstoffen, z. B. Kunstharzen. Durch Kombination mit duktilen Polymerwerkstoffen, z.B. durch Eingießen oder Verkleben, können für bestimmte Anwendungen Eigenschaftsverbesserungen erzielt werden. Die so entstandenen Piezokomposite zeichnen sich insbesondere durch eine reduzierte Bruchempfindlichkeit aus. Durch die Anordnung der piezokeramischen Werkstoffe im Verbund lassen sich zusätzlich Materialeigenschaften, wie z. B. Steifigkeit oder Dämpfung gezielt einstellen. Weiterhin können auch notwendige zusätzliche Komponenten, wie Elektroden, Energiezuleitungen, Isolatoren usw. eingebracht werden. Erst in einem zweiten Schritt werden die Aktuatoren und Sensoren mit dem Strukturwerkstoff bzw. der Struktur kombiniert.

Ein wesentliches Anwendungsfeld ist der Einsatz von Piezokompositen in der Ultraschalltechnik. Zum Aufbau von Ultraschallwandlern, die hauptsächlich in der medizinischen Diagnostik für zerstörungsfreie Werkstoffprüfung und in der Sonartechnik eingesetzt werden. In der Adaptronik werden Piezokomposite im Wesentlichen zur Reduzierung, Erzeugung oder Detektierung von Strukturverformungen zur Lärm-, Vibrations-, und Formkontrolle eingesetzt. Die Adaptronik setzt hierbei einen besonderen Schwerpunkt auf verteilte Aktuatorik und Sensorik. Im Gegensatz zu diskreten Aktuatoren, wie z. B. bei Piezostapelaktuatoren, erfolgt die Krafteinleitung nicht an zwei expliziten Punkten, sondern durch Schub über eine flächige Verbindung, in der Regel über eine Klebschicht. Insbesondere für den Leichtbau besitzen flächige Aktuatoren/Sensoren, die im Folgenden als Flächenaktuatoren bezeichnet werden, eine große Bedeutung, da keine massiven Krafteinleitungspunkte erforderlich sind. Gewichts- und bauraum-optimiert werden die Flächenaktuatoren (Aktuatoren und Sensoren) in dünnwandige Leichtbaustrukturen eingebracht und beeinflussen Schwingungen und Deformationen direkt am Ort ihrer Entstehung. Im Vergleich zu diskreten Aktuatoren, deren Steifigkeit und damit verbunden deren Effizienz prinzipbedingt mit zunehmender Länge abnimmt, können Flächenaktuatoren ohne Effizienzverlust in beliebiger Länge ausgeführt werden.

Auch hier gilt, dass durch die Kombination des spröden keramischen Materials mit einem Polymerwerkstoff verbesserte Eigenschaften erzielt werden. Der Verguss mit dem Polymer erfolgt in der Regel bei erhöhten Temperaturen, typischerweise 120°C. Durch unterschiedliche Wärmeausdehnungskoeffizienten des Polymerwerkstoffs und der Keramik sowie durch den Schrumpf des Polymers bei der Aushärtung ergibt sich eine Druckvorspannung des keramischen Materials in der Ebene. Dadurch können Piezokomposite in gewissen Grenzen auch auf Zug belastet werden.

Die wesentlichen Vorteile bei der Verwendung von Piezokompositen sind somit der Schutz der spröden Piezokeramik vor äußeren Belastungen, die verbesserte Handhabbarkeit, die einfache elektrische Kontaktierung, ein elektrisch isolierter Aktuator, die Druckvorspannung der Piezokeramik durch unterschiedliche thermische Ausdehnungskoeffizienten des Isolationsmaterials bzw. der Bettungsmasse und der Piezokeramik, der Abbau von Spannungsspitzen in der Keramik mit der Behinderung von Rissausbreitung, eine größere passive Verformbarkeit, eine erhöhte Lebensdauer der Wandler und die Möglichkeit zur Realisierung komplexer Architekturen.

Ausgangsmaterialien für die Herstellung von piezokeramischen Flächenaktuatoren sind hauptsächlich dünne piezokeramische Plättchen, die auch als Piezofolien bezeichnet werden, und piezokeramische Fasern, die mit unterschiedlichen Verfahren, Zusammensetzungen und Abmessungen hergestellt werden.

Von den drei richtungsabhängigen piezoelektrischen Teileffekten
- Längseffekt oder d₃₃-Effekt
- Quereffekt oder d₃₁-Effekt und
- Schereffekt oder d₁₅-Effekt
werden für Piezokomposite in der Adaptronik fast ausschließlich der Längs- und Quereffekt genutzt. Der Zusammenhang zwischen Dehnung und elektrischen Feld würde über die materialspezifische Ladungskonstante "d" beschrieben, wobei vereinfachend von einem linearen Zusammenhang zwischen Dehnung und elektrischem Feld ausgegangen wird. Die Indizes kennzeichnen dabei Ursache und Wirkung und beziehen sich auf Koordinatenrichtungen eines in der Materialwissenschaft gebräuchlichen Koordinatensystems.

Beim d₃₁-Effekt wird die Dehnung genutzt, die quer zum anliegenden elektrischen Feld entsteht. Das elektrische Feld wird in 3-Richtung aufgebracht (Ursache) und in 1-Richtung genutzt (Wirkung). Die d₃₁-Konstante ist negativ, da bei Anlegen eines positiven elektrischen Feldes in 3-Richtung eine Kontraktion der Piezokeramik in 1-Richtung erfolgt. Analog hierzu wird beim d₃₃-Effekt die Dehnung der Piezokeramik in 3-Richtung bei Anlegen eines positiven elektrischen Feldes in 3-Richtung genutzt. Da sich der keramische Körper in dieser Konfiguration ausdehnt, ist die d₃₃-Konstante positiv. Je nachdem welcher der beiden Effekte genutzt wird, wird auch von "Elongatoren" oder "Kontraktoren" gesprochen.

Die Anordnung der Elektroden ist daher entscheidend dafür, welcher der beiden Effekte genutzt wird. Der einfachste Aufbau für einen Flächenaktuator ergibt sich für den d₃₁-Effekt. In diesem Falle reicht eine einfache flächige Elektrode, die beidseitig auf einer dünnen Piezofolie aufgetragen wird. Das elektrische Feld bildet sich dann homogen zwischen den Elektroden aus. Die Dicke der Piezokeramik definiert aber den Elektrodenabstand und damit die erforderliche Spannung, um ein bestimmtes elektrisches Feld aufzubringen. Üblich ist eine Dicke von etwa 0,2 mm, bei der eine Spannung von 200 V erforderlich ist, um ein elektrisches Feld von 1 kV/mm zu erzeugen.

Piezokeramische Flächenaktuatoren, die den d₃₁-Effekt nutzen, sind beispielsweise in WO 95/20827, US 5,894,651 A und DE 100 51 784 C1 beschrieben. In der DE 100 51 784 C1 wird zur Kontaktierung der Elektroden vorgeschlagen, ein feines Netz aus Kupferdrähten zu verwenden, das während des Fertigungsprozesses zusammen mit der Piezokeramik in ein Polymer eingebettet wird und die Elektroden nahezu vollständig abdeckt. Dadurch ergibt sich insbesondere im Übergangsbereich vom aktiven zum passiven Bereich eine flexible und zuverlässige elektrische Verbindung, die auch bei hohen dynamischen Belastungen unempfindlich gegenüber der Entstehung von Rissen ist. Durch die vollständige Abdeckung der Elektrode wird sichergestellt, dass selbst bei einem Bruch alle Bruchstücke weiterhin kontaktiert werden und die Leistungsfähigkeit der Keramik nur geringfügig beeinflusst wird.

Monolithische d₃₃-Flächenkomposite sind beispielsweise aus der US 307,306 B1, DE 199 28 189 A1 und US 6,208.026 B1 bekannt. Zur Anbringung des elektrischen Feldes in 3-Richtung wird eine Kamm-Elektrode in eine kupferbeschichtete Polyamidfolie geätzt und mit der Folie verklebt. Problematisch ist der Einsatz von monolithischen Folien im Zusammenhang mit Kammelektroden. Elektrodenabstände und die Breite der Fingerelektrode sind vergleichsweise groß, damit die Auswirkung des inhomogenen elektrischen Feldes nicht zu Beschädigungen der Keramik im Betrieb führen.

Es ist auch bekannt, die monolithische Piezofolie mit Hilfe eines Lasers in Aktuatorlängsrichtung mehrfach einzuritzen, aber nicht völlig zu durchtrennen. Durch diese Maßnahme wird eine gerichtete Wirkung des Wandlers erreicht, da die Steifigkeit er Rillen größer ist, als quer dazu.

Aufgrund der inhomogenen elektrischen Felder sind monolithische Piezofolien nur bedingt für den Aufbau von d₃₃-Wandlern mit Kammelektroden geeignet.

Durch faserartige Architekturen des piezokeramischen Ausgangsmaterials wird versucht, die Dauerfestigkeitseigenschaften von Piezokompositen günstig zu beeinflussen, da Risse, die in einzelnen Piezofasern entstehen, sich nicht durch den ganzen Keramikkörper fortsetzen, sondern an den Grenzen zum Polymer gestoppt werden.

Bei Piezofaserkompositen werden piezokeramische Fasern in einer Monolage mit einem Polymer vergossen. Die Einbringung des elektrischen Feldes erfolgt wiederum über eine Kammelektrode unter Verwendung ätztechnisch hergestellter flexibler Leiterbahnen (Polyimidfolien) oder mit Leitklebstoff bedruckten Polyesterfolien.

Der Durchmesser der Einzelfasern liegt bei diesen Piezofaserkompositen zwischen 150 bis 250 µm. Ein wesentlicher Nachteil der Technologie liegt in der sehr aufwendigen Herstellung. Jede Faser muss einzeln eingebracht und im Komposit ausgerichtet werden. Zudem ist der Ausgangswerkstoff, die Piezofaser, im Vergleich zu Piezofolien um ein Vielfaches teurer.

Aus US 6,629,341 B2 ist die Nutzung preiswerter Piezofolien zur Herstellung von Piezofasem mit rechteckigem Querschnitt durch maschinellen Zuschnitt der Piezofolien bekannt. Für den Zuschnitt der Piezofolien werden Wafersägeh aus der Halbleiterindustrie eingesetzt. Nicht elektrodierte, monolithische Piezofolien werden in dünne Streifen gesägt und anschließend mit flexiblen Leiterbahnen aus Polyimid und geätzter Kammelektrodenstruktur verklebt. Durch das Sägen der Piezofolie ist die Steifigkeit des Aktuators quer zur Sägerichtung deutlich reduziert, wodurch sich auch für dieses Komposit eine gerichtete aktuatorische Wirkung ergibt. Durch den rechteckigen Faserquerschnitt und eine optimierte Elekrodengeometrie ergeben sich typische Dehnungswerte von 1.600 µm pro Meter bei einer Spannung von 1.500 V.

Eine wesentliche Forderung bei der Anwendung von aktuatorischen Piezokompositen ist ein größtmögliches Arbeitsvermögen. Die Aktuatoren müssen also möglichst hohe Kräfte und Wege erzeugen können. Die maximalen Kräfte und Wege werden durch den Werkstoff Piezokeramik vorgegeben. Obwohl die Dehnungen und Kräfte durch Nutzung des piezoelektrischen Längseffektes (d₃₃-Effekt) erreicht werden, haben die bisherigen technischen Lösungen zur Nutzung dieses d₃₃-Effektes, die auf kammartigen Oberflächenelektroden basieren, eine Reihe von Nachteilen. Dies sind die inhomogene Feldverteilung im keramischen Werkstoff, die hohe elektromechanische Belastung des piezokeramischen Werkstoffes in Bereichen mit hohen Feldgradienten, die Entstehung von Rissen in Bereichen mit hohen Feldgradienten, die Reduzierung der Lebensdauer durch Risse (elektrische Durchschläge), die Reduzierung der Steifigkeit des Aktuators durch Risse und damit eine Verringerung des Arbeitsvermögens, die erforderlichen extrem hohen Betriebsspannungen von bis zu 2 kV, um ausreichend hohe elektrische Felder erzeugen zu können, passive (ungenutzte) Bereiche unterhalb der Kammelektroden und die aufwendige und teure Fertigung.

Nachteilig ist auch, dass die Dicke der Aktuatoren sich nur sehr begrenzt einstellen lässt. Zwischen dem Elektrodenabstand und der Dicke des piezokeramischen Werkstoffes besteht ein direkter Zusammenhang. Je dicker der Werkstoff wird, desto größer muss auch der Elektrodenabstand gewählt werden, damit das Feld den gesamten Querschnitt durchdringen kann. Damit steigt aber gleichzeitig die Betriebsspannung an und wird unakzeptabel hoch. Dicken über 0,2 mm sind daher in der Regel nicht praktikabel. Zur Steigerung der Kraftwirkung des Aktuators wäre dies jedoch wünschenswert.

Sehr viel homogenere elektrische Felder werden bei der Nutzung des piezoelektrischen Quereffektes (d₃₁-Effekt) mit Flächenelektroden erreicht. Dadurch wird zwar eine Reihe von Nachteilen vermieden. Allerdings sind die maximal erreichbaren Dehnungen deutlich geringer und liegen bei ca. 35 % des d₃₃-Effektes. Dicke Aktuatoren führen auch hier zu einer Erhöhung der Betriebsspannung. Bei d₃₁-Wandlern ergibt sich die erforderliche Betriebsspannung zur Erzeugung eines geforderten elektrischen Feldes direkt aus dem Abstand der Elektroden und damit aus der Dicke des piezoelektrischen Werkstoffs. Je dicker der Werkstoff, desto höher die Betriebsspannung.

EP 1 090 835 A1 offenbart einen Flächenaktuator zum Verformen einer federnden Flächenstruktur in Normalrichtung zu der Oberfläche der Flächenstruktur mit mehreren Aktuatorelementen, die in Flächenstruktur eingebaut sind. Die Aktuatorelemente sind aus einem aktivierbaren Material gebildet und die Flächenstruktur ist federnd und anisotrop. Die Aktuatorelemente sind an zwei gegenüberliegenden Enden mit der Flächenstruktur verbunden und üben Zugkräfte aus.

EP 0 509 488 A1 offenbart einen Piezoaktuator, bei dem eine Vielzahl von piezokeramischen Platten übereinander gestapelt und mit Sammelelektroden an den gegenüberliegenden Seitenwänden kontaktiert sind. Die Sammelelektrodenflächen sind elektrisch mit zwischen Piezokeramikplatten liegenden Elektrodenflächen leitend verbunden.

WO 2005/067071 A1 offenbart eine piezokeramische Aktuatorstruktur mit piezokeramischen Stäben, die an ihrer Schmalseite nebeneinander zu einem Flächenaktuatorelement zusammengeschlossen sind.

Aufgabe der vorliegenden Erfindung ist es daher, einen verbesserten piezoelektrischen Flächenaktuator zu schaffen, der den d₃₃-Effekt ausnutzt und hohe Dehnungen bei geringen Betriebsspannungen erzeugen kann.

Die Aufgabe wird dem piezokeramischen Flächenaktuator der eingangs genannten Art dadurch gelöst, dass die Multilayerplatten in einen Kunststoff eingebettet sind und jeweils eine Sammelelektrodenfläche für zwei aneinander angrenzende Multilayerplatten vorgesehen ist, die jeweils die positiven oder negativen Elektroden der benachbarten Multilayerplatten kontaktiert.

Diese Flächenaktuatoren basieren auf piezokeramischen Multilayeraktuatoren, die eine Weiterentwicklung konventioneller piezokeramischer Stapelaktuatoren sind, Konventionelle Stapelaktuatoren werden aus geschichteten und miteinander verklebten piezokeramischen Platten hergestellt. Die Platten sind dabei flächig elektrodiert und dehnen sich bei Anlegen eines elektrischen Feldes unter Ausnutzung des d₃₃-Effektes in Dickenrichtung aus. Da die Dehnung einer Platte in Dickenrichtung gering ist, werden die Platten gestapelt, so dass sich die Dehnungen aller Platten addieren. Zur Kontaktierung der Elektroden werden in die Klebschichten dünne Kupferfolien eingebettet, die seitlich aus dem Stapel herausführen und wechselseitig kontaktiert werden. Da die Klebschichten die Steifigkeit des Aktuators und damit die Kraftwirkung des Aktuators reduzieren, wurden piezokeramische Multilayeraktuatoren entwickelt, bei denen die Elektroden als sehr dünne Schichten (wenige µm) auf den keramischen Grünkörper der Piezokeramik aufgebracht und anschließend mit der Piezokeramik gesintert wird. Dadurch ist die Elektrode Bestandteil des monolithischen Keramikkörpers. Weil keine Polymerwerkstoffe zum Aufbau des Aktuators benötigt werden, ist der Multilayeraktuator deutlich steifer als ein konventioneller Stapelaktuator. Zudem ermöglicht diese Bauweise eine Reduzierung der Betriebsspannung, da mehr Elektroden mit geringerem Abstand in den Stapel eingebracht werden können, ohne dass die Steifigkeit des Aktuators drastisch abnimmt.

Basierend auf diesen an sich bekannten quaderförmigen Multilayeraktuatoren wird mit der vorliegenden Erfindung vorgeschlagen, einen piezokeramischen Aktuator zu schaffen, der nicht quaderförmig, sondern plattenförmig ist. Typische Dicken liegen im Bereich von 0,1 bis 0,3 mm und vorzugsweise etwa 0,2 mm. Typische Breiten liegen im Bereich von 10 bis 20 mm. Damit kann auch für einen Flächenaktuator der Vorteil der quaderförmigen Multilayeraktuatoren einer homogenen Feldverteilung in den aktuatorisch wirksamen Bereichen des Piezokomposits, einer geringen elektromechanischen Belastung des piezokeramischen Werkstoffs in den aktuatorisch wirksamen Bereichen, einer deutlich geringeren Betriebsspannung bei gleicher aktiver Dehnung und der fehlende Einfluss der Keramikdicke auf die Betriebsspannung genutzt werden. Durch die Einbettung in einem Kunststoff, wie z.B. einem Polymer, einem Faserverbund etc. wird erreicht, dass der Flächenaktuator mechanisch stabilisiert, handhabbar und elektrisch isoliert ist.

Vorzugsweise sind die Elektroden mit den Piezokeramikplatten zu einem monolithischen Keramikkörper gesintert, um einen integralen monolithischen Keramikblock zu bilden, der in Form einer dünnen Platte bzw. Scheibe für den Flächenaktuator eingesetzt wird.

Besonders vorteilhaft ist es, wenn auf den Sammelelektrodenflächen für die positiven und negativen Elektroden jeweils eine elektrisch leitende elastische Kontaktfläche aufgebracht ist. Auf diese Weise wird für die positiven Elektroden eine elektrische Kontaktierung über die positive Sammelelektrodenfläche und die darauf aufliegende Kontaktfläche gewährleistet. Entsprechend ist eine negative Kontaktfläche für die negativen Elektroden vorgesehen, die auf der negativen Sammelelektrodenfläche aufliegt. Die zusätzliche elastische Kontaktfläche führt zu einer hohen Zuverlässigkeit und Lebensdauer des Piezokomposits. Sie verhindert, dass sich Risse, die sich in der Piezokeramik bilden können, zu einem Ausfall des Aktuators führen. Prinzipbedingt ergeben sich nämlich an den Enden der Elektrodenfinger Bereiche mit inhomogenen Feldern. Diese Inhomogenitäten führen zu einer mechanischen Belastung des Keramikwerkstoffes, wodurch letztendlich Risse entstehen können. Diese Risse sind für die Funktion unkritisch, da sie örtlich begrenzt sind, können jedoch die Sammelelektrodenfläche am Rand des Flächenaktuators beschädigen. Durch die elastische Kontaktfläche wird die Gefahr einer solchen Beschädigung reduziert.

Die elektrisch leitende elastische Kontaktfläche sollte wesentlich dicker als die Sammelelektrodenfläche sein. Sie kann beispielsweise aus einem elektrisch leitendem Vliesmaterial, einem Kupfergewebe oder einem Kohlenstoffgewebe gebildet sein. Besonders vorteilhaft ist die Nutzung eines metallisierten Polyestervliesmaterials für die Kontaktfläche.

Bei der Bildung eines Flächenaktuatorverbundes aus mehreren nebeneinander angeordneten Flächenaktuatoren ist es vorteilhaft, die Kontaktelektrodenfläche in einem Harzinjektionsverfahren mit der mindestens einen Multilayerplatte integral zu verbunden.

Insbesondere um eine Vorspannung des piezokeramischen Flächenaktuators zu schaffen, die neben der Druckbelastung auch eine Zugbelastung erlaubt, ist es vorteilhaft, mindestens einen Flächenaktuator in einen Polymerverbund einzubetten und über Leiterbahnen auf Lagen des Polymerverbunds elektrisch zu kontaktieren. Die Leiterbahnen können beispielsweise auf obere und/oder untere Lagen des Polymerverbunds gedruckt oder geätzt sein.

Aufgabe der vorliegenden Erfindung ist es weiterhin, ein verbessertes Verfahren zur Herstellung eines solchen piezokeramischen Flächenaktuators mit den Schritten:
a) Herstellen eines monolithischen quaderförmigen Keramikblocks bestehend aus einer Vielzahl von durch jeweils eine positive oder negative Elektrode voneinander getrennten Piezokeramikplatten, wobei sich die positiven und negativen Elektroden alternierend abwechseln und integral mit den Piezokeramikplatten aufgebaut sind, und
b) Aufbringen von elektrisch leitenden Sammelelektrodenflächen auf zwei sich gegenüberliegende Außenseiten des Keramikblocks derart, dass die Sammelelektrodenflächen mit den zugeordneten positiven oder negativen Elektroden leitend verbunden werden;
zu schaffen.

Die Aufgabe wird mit diesem Verfahren gelöst durch die weiteren Schritte:
c) Schneiden des quaderförmigen Keramikblocks in plattenförmige Multilayerplatten so, dass die Piezokeramikplatten eine wesentlich größere durch den Abstand der gegenüberliegenden Sammelelektrodenflächen definierten Breite haben, als die Dicke der Multilayerplatten,
d) Kontaktieren jeweils der positiven oder negativen Elektroden der benachbarten Multilayerplatten mit einer gemeinsamen Sammelelektrodenfläche; und
e) Einbetten des Flächenaktuators in einen Kunststoff.

Vorteilhafte Ausführungsformen sind in den Unteransprüchen beschrieben.

Die Erfindung wird nachfolgend beispielhaft anhand der beigefügten Zeichnungen näher erläutert. Es zeigen:
- Fig. 1 a) bis e) -: Skizze des Verfahrens zur Herstellung eines piezokerami-schen Flächenaktuators aus einem monolithischen quaderförmigen mehrschichtigen Piezokeramikblock;
- Fig. 2 -: perspektivische Explosionsansicht von zwei nebeneinan-der angeordneten und in einen Polymerverbund eingebetteten Flächenaktuatoren;
- Fig. 3 -: beispielhafte Spannungs-Dehnungskurve eines in einemPolymerverbund eingebetteten piezokeramischen Flächenaktuators.

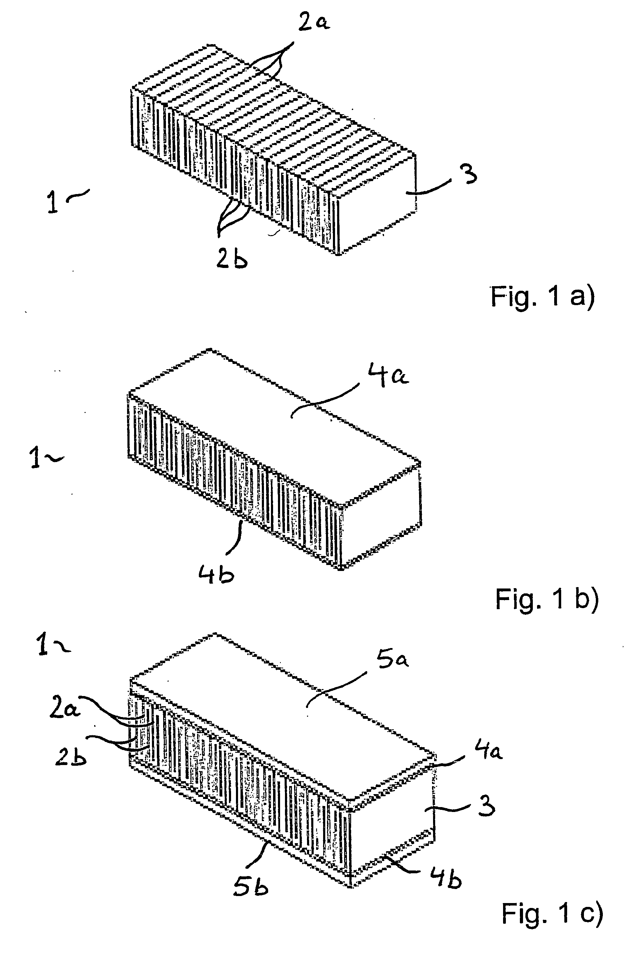

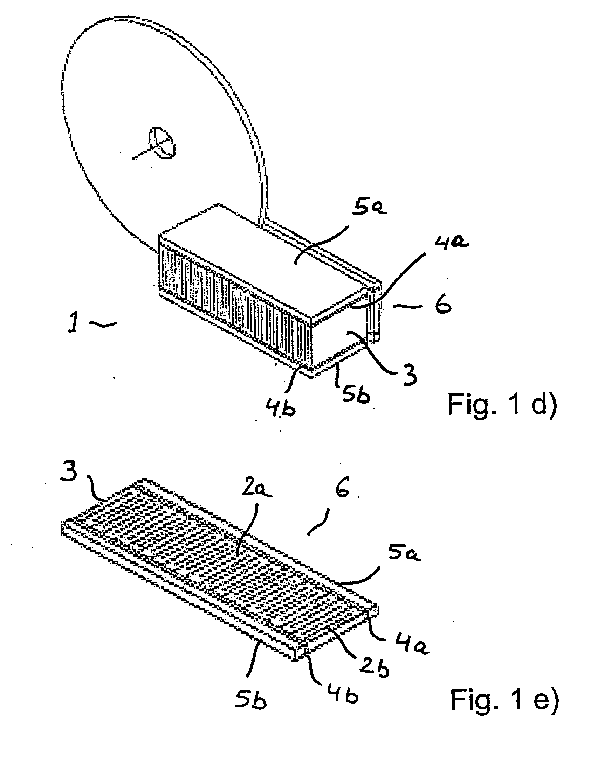

Figur 1 lässt in perspektivischer Ansicht skizzenhaft die Herstellung eines plattenförmigen piezokeramischen Flächenaktuators erkennen.

Fig. 1 a) zeigt einen industriell verfügbaren monolithischen Multilayerstack 1 als Ausgangspunkt des Verfahrens. Der Multilayerstack 1 ist ein monolithischer Keramikkörper, bei dem positive und negative Elektroden 2a, 2b mit Keramikplatten 3 zu einem monolithischen Keramikkörper gesintert sind. Die positiven und negativen Elektroden 2a, 2b sind alternierend abwechselnd zwischen jeweils zwei aneinander angrenzende Piezokeramikplatten 3 angeordnet.

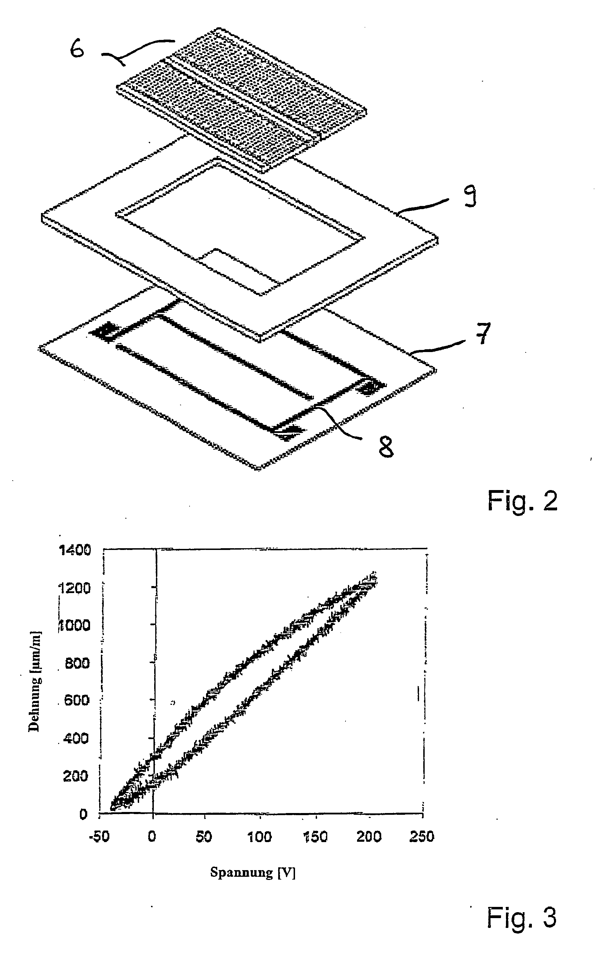

Fig. 2 lässt erkennen, dass zur elektrischen Kontaktierung der einzelnen fingerartigen Elektroden 2a, 2b jeweils eine dünne Sammelelektrodenfläche 4a, 4b auf zwei gegenüberliegenden Außenseiten des monolithischen Keramikkörpers 1 aufgebracht sind. Die Sammelelektrodenflächen 4a, 4b können beispielsweise durch Sputtern oder Siebdruck hergestellt werden.

Äußere Lasten oder die durch den aktiven Betrieb des piezokeramischen Flächenaktuators erzeugten Dehnungen können zu Rissen in den dünnen Sammelelektroden 4a, 4b führen. Dies würde je nach Ort des Risses zu einem teilweisen oder völligen Ausfall des Flächenaktuators führen. Zur Vermeidung dieses Problems wird, wie in der Figur 1c skizziert ist, auf die Sammelelektrodenflächen 4a, 4b eine elektrisch leitende, elastische Kontaktfläche 5a, 5b aufgebracht. Das Material der Kontaktflächen 5a, 5b ist dicker als die Sammelelektrodenfläche 4a, 4b, die auch entfallen kann, so dass die Sammelelektrodenfläche 4a, 4b selbst als elektrisch leitende, elastische Schicht ausgeführt ist.

Für die elastischen Kontaktflächen 5a, 5b kommen elektrisch leitende Vliese, z. B. metallisiertes Polyestervlies, Kupfergewebe, Kohlenstoffgewebe oder ähnliches zum Einsatz. Die Aufbringung des elektrisch leitenden Materials erfolgt vorzugsweise mit einem Harzinjektionsverfahren, wobei auch andere Verfahren möglich sind. Zur Rationalisierung des Prozesses werden mehrere mehrschichtige monolithische Keramikkörper 1 zu einem Block zusammengefasst und gleichzeitig mit der elektrisch leitenden elastischen Kontaktfläche 5a, 5b versehen.

Figur 1 d) lässt erkennen, dass in dem nächsten Schritt der so vorbereitete monolithische Keramikkörper 1 mit einer Säge in dünne Scheiben geschnitten wird. Um den Sägeprozess zu vereinfachen, können vorher zusätzliche Bereiche zur Klemmung der Keramiken angebracht sein.

Figur 1 e) lässt einen plattenförmigen piezokeramischen Flächenaktuator als Ergebnis des Sägeprozesses erkennen. In dieser dünnen Multilayerplatte 6 sind die Elektroden nicht nur oberflächlich angeordnet, wie bei herkömmlichen d₃₃-Flächenkompositen mit Oberflächenelektroden, sondern durchdringen den Querschnitt nahezu vollständig. Es bilden sich sehr homogene elektrische Felder aus. Die Elektrodenabstände können wesentlich reduziert werden, z. B. auf 50 µm, wodurch sich bei gleicher Dehnung auch wesentlich reduzierte Betriebsspannungen ergeben. Die Dicke der Multilayerplatte 6 beeinflusst aber nicht die Höhe der erforderlichen elektrischen Spannung. Die aktive Querschnittsfläche kann daher über weite Bereiche beliebig angepasst werden.

Die in der Fig. 1 e) dargestellte Multilayerplatte 6 ist allerdings sehr bruchempfindlich. Zur mechanischen Stabilisierung, elektrischen Isolierung und Kontaktierung kann die Multilayerplatte 6 in einen Polymerverbund eingebettet sein, wie in der Fig. 2 dargestellt ist. Der Polymerverbund besteht aus zwei äußeren Lagen 7, von denen nur eine skizziert ist. Auf die Lagen 7 werden Leiterbahnenstrukturen aufgebracht. Vorzugsweise werden gedruckte oder geätzte Leiterbahnen auf Polyamid- oder Polyestersubstraten verwendet. Die Leiterbahnen 8 sind so angeordnet, dass die elastischen Kontaktflächen 5a, 5b exakt auf ihnen abgelegt werden können. Dabei können Flächenaktuatoren mit einer beliebigen Zahl oder Anordnung von Multilayerplatten 6 aufgebaut werden, um die Fläche des Piezokomposits nach Bedarf zu vergrößern. Die Verklebung der einzelnen Komponenten kann direkt erfolgen. In dem dargestellten Beispiel kommt jedoch ein Harzinjektionsverfahren zum Einsatz, bei dem zusätzlich ein Rahmen 9 aus einem isolierenden Fasermaterial, vorzugsweise Polyestervlies, verwendet wird. Dieser Rahmen 9 dient als Abstandshalter und positioniert die Multilayerplatten 6 im Verbund. Weiterhin ermöglicht der Rahmen 9 den Harzfluss während des Injektionsvorganges. Die Verwendung eines Harzinjektionsverfahrens garantiert eine hohe Bauteilqualität und Reproduzierbarkeit.

Da die Auswertung des Komposits bei erhöhten Temperaturen erfolgt, vorzugsweise im Bereich von 120°C bis 180°C, bildet sich beim Abkühlprozess eine vorteilhafte Druckvorspannung im keramischen Körper aus. Diese ist bedingt durch den höheren thermischen Ausdehnungskoeffizienten des umgebenden Polymermaterials im Vergleich zur Piezokeramik.

Zur Rationalisierung des Prozesses können mehrer Piezokomposite gleichzeitig hergestellt und nachträglich vereinzelt werden. Das so entstandene Piezokomposit ist robust und einfach zu handhaben und kann als Flächenaktuator für beliebige Anwendungen verwendet werden.

Figur 3 lässt eine Spannungs-Dehnungskurve eines in einem Polymerverbund eingebetteten piezokeramischen Flächenaktuators erkennen. Die Dehnung ist in der Einheit µm/m über der Ansteuerspannung für den piezokeramischen Flächenaktuator aufgetragen. Es wird deutlich, dass bei einer Betriebsspannung von 200 V eine maximale Dehnung von 1.300 µm/m erreicht wird. Je nach Größe und Aufbau sind aber höhere Werte bis mindestens 1.800 µm/m bei einer Spannung von unter 120 V erreichbar. Der Spannungsbereich für die Ansteuerung liegt bei etwa minus 50 bis 200 V. Die mittlere Dehnung beträgt in dem dargstellten Beispiel etwa 4,8 µm/m/V.

## Patentansprüche

1. Piezokeramischer Flächenaktuator mit Multilayerplatten (6), die eine Vielzahl von durch jeweils eine positive oder negative Elektrode (2a, 2b) voneinander getrennte Piezokeramikplatten (3) haben, wobei sich die positiven und negativen Elektroden (2a, 2b) alternierend abwechseln und integral mit den Piezokeramikplatten (3) aufgebaut sind, und mit Sammelelektrodenflächen (4a, 4b) für die positiven und negativen Elektroden (2a, 2b), die mit den zugeordneten positiven oder negativen Elektroden (2a, 2b) leitend verbunden und auf zwei sich gegenüberliegenden Außenseiten der Multilayerplatten (6) angeordnet sind, wobei die Multilayerplatten (6) plattenförmig sind mit einer wesentlich größeren durch den Abstand der gegenüberliegenden Sammelelektrodenflächen (4a, 4b) definierten Breite der Multilayerplatten (6) als der Dicke der Multilayerplatten (6), **dadurch gekennzeichnet, dass** die Multilayerplatten (6) in einen Kunststoff eingebettet sind und dass jeweils eine Sammelelektrodenflache (4a, 4b) für zwei aneinander angrenzende Multilayerplatten (6) vorgesehen ist und jeweils die positiven oder negativen Elektroden (2a, 2b) der benachbarten Multilayerplatten (6) kontaktiert.

2. Piezokeramischer Flächenaktuator nach Anspruch 1, **dadurch gekennzeichnet, dass** die Elektroden mit den Piezokeramikplatten (3) zu einem monolithischen Keramikkörper (1) gesintert sind.

3. Piezokeramischer Flächenaktuator nach Anspruch 1 oder 2, **dadurch gekennzeichnet, dass** die Sammelelektrodenflächen (4a, 4b) elastisch sind.

4. Piezokeramischer Flächenaktuator nach Anspruch 1 oder 2, **dadurch gekennzeichnet, dass** auf den Sammelelektrodenflächen (4a, 4b) für die positiven und negativen Elektroden (2a, 2b) jeweils eine elektrisch leitende elastische Kontaktfläche (5a, 5b) aufgebracht ist.

5. Piezokeramischer Flächenaktuator nach Anspruch 3, **dadurch gekennzeichnet, dass** die elektrisch leitende elastische Kontaktfläche (5a, 5b) wesentlich dicker als die Sammelelektrodenfläche (4a, 4b) ist.

6. Piezokeramischer Flächenaktuator nach Anspruch 3 oder 4, **dadurch gekennzeichnet, dass** die Sammelelektrodenflächen (4a, 4b) aus elektrisch leitendem Vliesmaterial; wie beispielsweise einem metallisiertem Polyestervliesmaterial, aus Kupfergewebe oder Kohlenstoffgewebe gebildet sind.

7. Piezokeramischer Flächenaktuator nach einem der Ansprüche 3 bis 6, **dadurch gekennzeichnet, dass** die Sammelelektrodenflächen (4a, 4b) in einem Harzinjektionsverfahren mit der mindestens einen Multilayerplatte (6) integral verbunden sind.

8. Piezokeramischer Flächenaktuator nach einem der vorhergehenden Ansprüche, **dadurch gekennzeichnet, dass** mindestens eine Multilayerplatte (6) in einen Polymerverbund eingebettet und über Leiterbahnen (8) auf Lagen (7) des Polymerverbunds elektrisch kontaktiert sind.

9. Piezokeramischer Flächenaktuator nach Anspruch 8, **dadurch gekennzeichnet, dass** die Leiterbahnen (8) auf obere und/oder untere Lagen (7) des Polymerverbunds gedruckt oder geätzt sind.

10. Piezokeramischer Flächenaktuator nach einem der vorhergehenden Ansprüche, **dadurch gekennzeichnet, dass** die Multilayerplatten (6) unter Vorspannung durch die Sammelelektrodenfläche (4a, 4b) oder den Polymerverbund stehen.

11. Verfahren zur Herstellung eines piezokeramischen Flächenaktuators mit den Schritten:
a) Herstellen eines monolithischen quaderförmigen Keramikblocks bestehend aus einer Vielzahl von durch jeweils eine positive oder negative Elektrode (2a, 2b) voneinander getrennten Piezokeramikplatten (3), wobei sich die positiven und negativen Elektroden (2a, 2b) alternierend abwechseln und integral mit den Piezokeramikplatten (3) aufgebaut sind;
b) Aufbringen von elektrisch leitenden Sammelelektrodenflächen (4a, 4b) auf zwei sich gegenüberliegende Außenseiten des Keramikblocks derart, dass die Sammelelektrodenflächen (4a, 4b) mit den zugeordneten positiven oder negativen Elektroden (2a, 2b) leitend verbunden werden,
c) Schneiden des quaderförmigen Keramikblocks in plattenförmige Multilayerplatten (6) so, dass die Multilayerplatten (6) eine wesentlich größere durch den Abstand der gegenüberliegenden Sammelelektrodenflächen (4a, 4b) voneinander definierten Breite haben, als die Dicke der Multilayerplatten (6),
d) Kontaktieren jeweils der positiven oder negativen Elektroden der benachbarten Multilayerplatten mit einer gemeinsamen Sammelelektrodenfläche; und
e) Einbetten des Flächenaktuators in einen Kunststoff.

12. Verfahren nach Anspruch 11, **gekennzeichnet durch** Sintern der Elektroden zusammen mit den Piezokeramikplatten (3) zu einem monolithischen Keramikblock im Schritt a).

13. Verfahren nach Anspruch 11 oder 12, **gekennzeichnet durch** Aufbringen jeweils einer elektrisch leitenden elastischen Kontaktfläche (5a, 5b) auf den Sammelelektroden für die positiven und negativen Elektroden (2a, 2b).

14. Verfahren nach Anspruch 13, **dadurch gekennzeichnet, dass** die elastisch leitende elastische Kontaktfläche (5a, 5b) wesentlich dicker als die Sammelelektrode (4a, 4b) ist,

15. Verfahren nach einem der Ansprüche 13 oder 14, **dadurch gekennzeichnet, dass** die Sammelelektrodenflächen (4a, 4b) aus elektrisch leitendem Vliesmaterial, beispielsweise aus einem metallisierten Polyestervliesmaterial, aus Kupfergewebe oder Kohlenstoffgewebe gebildet sind.

16. Verfahren nach einem der Ansprüche 11 bis 15, **gekennzeichnet durch** integrales Verbinden der Sammelelektrodenflächen (4a, 4b) in einem Harzinjektionsverfahren mit den Multilayerplatten (6).

17. Verfahren nach einem der Ansprüche 11 bis 16, **gekennzeichnet durch** Einbetten der Multilayerplatten (6) in einen Polymerverbund und elektrisches Kontaktieren des mindestens einen Flächenaktuators über Leiterbahnen (8) auf Lagen (7) des Polymerverbunds.

18. Verfahren nach Anspruch 19, **gekennzeichnet durch** Drucken oder Ätzen der Leiterbahnen (8) auf obere und/oder untere Lagen (7) des Polymerverbunds.

## Claims

1. A piezoceramic surface actuator comprising multilayer plates (6) having a plurality of piezoceramic plates (3) separated from one another by in each case a positive or negative electrode (2a, 2b), wherein the positive and negative electrodes (2a, 2b) alternate and are constructed integrally with the piezoceramic plates (3), and having collector electrode surfaces (4a, 4b) for the positive and negative electrodes (2a, 2b), which are connected to the associated positive or negative electrodes (2a, 2b) in a conducting manner and are arranged on two exterior sides of the multilayer plates (6) that are opposite from one another, wherein the multilayer plates (6) are plate-shaped and having a much greater width of the multilayer plates (6), defined by the distance between the opposite collector electrode surfaces (4a, 4b), than the thickness of the multilayer plates (6) **characterized in that** the multilayer plates (6) are embedded in a plastic and that a collector electrode surface (4a, 4b) is respectively provided for two mutually adjacent multilayer plates (6) and in each case contacts the positive or negative electrodes (2a, 2b) of the neighboring multilayer plates (6).

2. The piezoceramic surface actuator as claimed in claim 1, **characterized in that** the electrodes are sintered with the piezoceramic (3) to form a monolithic ceramic body (1).

3. The piezoceramic surface actuator as claimed in claim 1 or 2, **characterized in that** the collector electrode surfaces (4a, 4b) are elastic.

4. The piezoceramic surface actuator as claimed in claim 1 or 2, **characterized in that** an electrically conducting elastic contact area (5a, 5b) is respectively applied to the collector electrode surfaces (4a, 4b) for the positive and negative electrodes (2a, 2b).

5. The piezoceramic surface actuator as claimed in claim 3, **characterized in that** the electrically conducting elastic contact area (5a, 5b) is much thicker than the collector electrode surface (4a, 4b)

6. The piezoceramic surface actuator as claimed in claim 3 or 4, **characterized in that** the collector electrode surfaces (4a, 4b) are formed from electrically conducting nonwoven material, such as for example a metallized polyester nonwoven material, from copper cloth or carbon cloth.

7. The piezoceramic surface actuator as claimed in one of claims 3 to 6, **characterized in that** the collector electrode surfaces (4a, 4b) are integrally connected to the at least one multilayer plate (6) in a resin injection process.

8. The piezoceramic surface actuator as claimed in one of the preceding claims, **characterized in that** at least one multilayer plate (6) is embedded in a polymer composite and electrically contacted by way of conductor tracks (8) on layers (7) of the polymer composite.

9. The piezoceramic surface actuator as claimed in claim 8, **characterized in that** the conductor tracks (8) are printed or etched on the upper and/or lower layers (7) of the polymer composite.

10. The piezoceramic surface actuator as claimed in one of the preceding claims, **characterized in that** multilayer plate (6) are under prestress through the collector electrode surface (4a, 4b) or the polymer composite.

11. Method for producing a piezoceramic surface actuator with the steps of:
a) producing a monolithic cuboidal ceramic block comprising a plurality of piezoceramic plates (3) separated from one another by in each case a positive or negative electrode (2a, 2b), wherein the positive and negative electrodes (2a, 2b) alternate and are constructed integrally with the piezoceramic plates (3);
b) applying electrically conducting collector electrode surfaces (4a, 4b) to two opposite exterior sides of the ceramic block in such a way that the collector electrode surfaces (4a, 4b) are connected to the associated positive or negative electrodes (2a, 2b) in a conducting manner,
c) cutting the cuboidal ceramic block into plate-shaped multilayer plates (6) actuators such that the multilayer plates (6) have a much greater width, defined by the spacing of the opposite collector electrode surfaces (4a, 4b), than the thickness of the multilayer plates (6),
d) contacting the positive or negative electrodes (2a, 2b) of the neighboring multilayer plates (6) with a common collector electrode surface (4a, 4b).
e) embedding the surface actuator in a plastic.

12. Method as claimed in claim 11, **characterized by** sintering the electrodes together with the piezoceramic plates (3) to form a monolithic ceramic block in step a).

13. Method as claimed in claim 11 or 12, **characterized by** applying an electrically conducting elastic contact area (5a, 5b) respectively to the collector electrode surfaces for the positive and negative electrodes (2a, 2b).

14. Method as claimed in claim 13, **characterized in that** the electrically conducting elastic contact area (5a, 5b) is much thicker than the collector electrode surface (4a, 4b).

15. Method as claimed in either of claims 13 and 14, **characterized in that** the collector electrode surfaces (4a, 4b) are formed from electrically conducting nonwoven material, for example from a metallized polyester nonwoven material, from copper cloth or carbon cloth.

16. Method as claimed in one of claims 11 to 15, **characterized by** integrally connecting the collector electrode surfaces (4a, 4b) to the multilayer plates (6) in a resin injection process.

17. Method as claimed in one of claims 11 to 16, **characterized by** embedding the multilayer plates (6) in a polymer composite and electrically contacting the at least one surface actuator by way of conductor tracks (8) on layers (7) of the polymer composite.

18. Method as claimed in claim 17, **characterized by** printing or etching the conductor tracks (8) on upper and/or lower layers (7) of the polymer composite.

## Revendications

1. Actionneur piézocéramique de surface doté de plaques multicouches (6) qui possèdent plusieurs plaques (3) de piézocéramique séparées les unes des autres par une électrode positive ou une électrode négative (2a, 2b) respective,
les électrodes positives et les électrodes négatives (2a, 2b) étant montées en alternance et d'un seul tenant avec les plaques (3) en piézocéramique et présentant des surfaces (4a, 4b) d'électrode de collecte prévues pour les électrodes positives et les électrodes négatives (2a, 2b), reliées de manière conductrice aux électrodes positives ou négatives (2a, 2b) qui leur sont associées et disposées sur deux côtés extérieurs opposés des plaques multicouches (6),
la largeur des plaques multicouches (6) définie par la distance entre les surfaces opposées (4a, 4b) des électrodes de collecte étant beaucoup plus grande que l'épaisseur des plaques multicouches (6), **caractérisé en ce que**
les plaques multicouches (6) sont incorporées dans une matière synthétique et
**en ce que** chaque surface (4a, 4b) d'électrode de collecte est prévue pour deux plaques multicouches (6) mutuellement adjacentes et est en contact avec les électrodes positives ou négatives (2a, 2b) des plaques multicouches (6) voisines.

2. Actionneur piézocéramique de surface selon la revendication 1, **caractérisé en ce que** les électrodes sont frittées avec les plaques (3) en piézocéramique pour former un corps monolithique (1) en céramique.

3. Actionneur piézocéramique de surface selon les revendications 1 ou 2, **caractérisé en ce que** les surfaces (4a, 4b) d'électrode de collecte sont élastiques.

4. Actionneur piézocéramique de surface selon les revendications 1 ou 2, **caractérisé en ce qu'**une surface de contact (5a, 5b) électriquement conductrice et élastique est appliquée sur les surfaces (4a, 4b) d'électrode de collecte prévues pour les électrodes positives et les électrodes négatives (2a, 2b).

5. Actionneur piézocéramique de surface selon la revendication 3, **caractérisé en ce que** la surface de contact (5a, 5b) électriquement conductrice et élastique est beaucoup plus épaisse que la surface (4a, 4b) d'électrode de collecte.

6. Actionneur piézocéramique de surface selon les revendications 3 ou 4, **caractérisé en ce que** les surfaces (4a, 4b) d'électrode de collecte sont formées d'un matériau en feutre électriquement conducteur, par exemple un matériau en feutre de polyester métallisé, un tissu de cuivre ou un tissu de carbone.

7. Actionneur piézocéramique de surface selon l'une des revendications 3 à 6, **caractérisé en ce que** les surfaces (4a, 4b) d'électrode de collecte sont reliées d'un seul tenant à la ou aux plaques multicouches (6) dans une opération d'injection de résine.

8. Actionneur piézocéramique de surface selon l'une des revendications précédentes, **caractérisé en ce qu'**au moins une plaque multicouches (6) est incorporée dans un ensemble polymère et est mise en contact électrique avec des couches (7) de l'ensemble polymère à l'aide de pistes conductrices (8).

9. Actionneur piézocéramique de surface selon la revendication 8, **caractérisé en ce que** les pistes conductrices (8) sont imprimées ou gravées sur les couches supérieures et/ou les couches inférieures (7) de l'ensemble polymère.

10. Actionneur piézocéramique de surface selon l'une des revendications précédentes, **caractérisé en ce que** les plaques multicouches (6) sont placées sous précontrainte par les surfaces (4a, 4b) d'électrode de collecte ou l'ensemble polymère.

11. Procédé de fabrication d'un actionneur piézocéramique de surface, le procédé présentant les étapes qui consistent à :
a) préparer un bloc parallélépipédique monolithique en céramique constitué de plusieurs plaques (3) en piézocéramique séparées les unes des autres par des électrodes positives ou des électrodes négatives (2a, 2b), les électrodes positives et les électrodes négatives (2a, 2b) étant montées en alternance et d'un seul tenant avec les plaques (3) en piézocéramique,
b) placer des surfaces (4a, 4b) électriquement conductrices d'électrode de collecte sur deux côtés extérieurs opposés du bloc en céramique de telle sorte que les surfaces (4a, 4b) d'électrode de collecte soient reliées de manière conductrice aux électrodes positives ou aux électrodes négatives (2a, 2b) qui leur sont associées,
c) découper le bloc parallélépipédique en céramique en plaques multicouches (6) en forme de plaque de telle sorte que les plaques multicouches (6) possèdent une largeur, définie par la distance entre les surfaces opposées (4a, 4b) d'électrode de collecte, beaucoup plus grande que l'épaisseur des plaques multicouches (6),
d) mettre en contact les électrodes positives ou les électrodes négatives des plaques multicouches voisines avec une surface commune d'électrode de collecte et
e) incorporer l'actionneur de surface dans une matière synthétique.

12. Procédé selon la revendication 11, **caractérisé par** le frittage des électrodes avec les plaques (3) en piézocéramique pour former un bloc céramique monolithique à l'étape a).

13. Procédé selon les revendications 11 ou 12, **caractérisé par** l'application d'une surface de contact (5a, 5b) électriquement conductrice et élastique sur les électrodes de collecte prévues pour les électrodes positives et les électrodes négatives (2a, 2b).

14. Procédé selon la revendication 13, **caractérisé en ce que** la surface de contact (5a, 5b) électriquement conductrice et élastique est beaucoup plus épaisse que l'électrode de collecte (4a, 4b).

15. Procédé selon l'une des revendications 13 ou 14, **caractérisé en ce que** les surfaces (4a, 4b) d'électrode de collecte sont formées d'un matériau en feutre électriquement conducteur, par exemple un matériau en feutre de polyester métallisé, un tissu de cuivre ou un tissu de carbone.

16. Procédé selon l'une des revendications 11 à 15, **caractérisé par** la liaison d'un seul tenant des surfaces (4a, 4b) d'électrode de collecte avec les plaques multicouches (6) dans une opération d'injection de résine.

17. Procédé selon l'une des revendications 11 à 16, **caractérisé par** l'incorporation des plaques multicouches (6) dans un ensemble polymère et par la mise en contact électrique du ou des actionneurs de surface avec des couches (7) de l'ensemble polymère par l'intermédiaire de pistes conductrices (8).

18. Procédé selon la revendication 17, **caractérisé par** l'impression ou la gravure des pistes conductrices (8) sur les couches supérieures et/ou les couches inférieures (7) de l'ensemble polymère.
